# EUROPEAN PATENT SPECIFICATION

(11) **EP 0 345 487 B1**
(45) Date of publication and mention of the grant of the patent: **16.02.1994**
(21) Application number: 89108689.4
(22) Date of filing: 13.05.1989
(51) Int. Cl.: C23C 14/34

(54) **A sputtering method for fabricating thin film**
Sputterverfahren zur Erzeugung einer Dünnschicht
Procédé de pulvérisation pour fabrication de couche mince

(30) Priority: 10.06.1988 JP 141507/88
(43) Date of publication of application: 13.12.1989
(73) Proprietor: FUJITSU LIMITED, Kawasaki-shi, Kanagawa 211 (JP)
(72) Inventor: Inoue, Minoru, Takatsu-ku Kawasaki-shi Kanagawa, 213 (JP)
(74) Representative: Seeger, Wolfgang, Dipl.-Phys.

(56) References cited:
- US-A- 4 428 812
- US-A- 4 440 618

## Description

The present invention relates to a method for fabricating thin films of various materials by electric glow discharge in gas. Especially it relates to a sputtering method having a high sputtering efficiency at low gas pressure which assures a low contamination and high grade of the sputtered film, still keeping low consumption of the gas.

Sputtered thin films are used in variety of industries, such as production of semiconductor devices, thin film circuit board, optical equipments and so on. There are several methods for forming thin films. Among them the electrical sputtering is one of the most widely used method, and it can be applied for sputtering various materials such as metal, dielectric or semiconductor materials.

Sputtering is a method to bombard a material to be sputtered with ions in a plasma formed by electric discharge, and sputter the material to form a film on an object. Recently, in order to increase the sputtering efficiency, a magnetic field is applied to focus the ion stream on the target formed by the material to be sputtered. Such method is called in the art magnetron sputtering.

Quality of the sputtered film largely depends on the sputtering condition. On the other hand stability and purity of the thin film is required in modern applications. For example, in recent very large scale integrated (VLSI) semiconductor circuits, the device design became very fine, so, the quality of wirings made of an aluminum thin film affects the reliability of the devices. If oxygen or humidity are included in the sputtered aluminium film, the wirings often looks white because of small unevenness formed on the aluminum surface. The electrical conductivity of such wirings are low, and cause disconnection by migration of aluminum.

The maintenance of the sputtering equipment must be very careful. The sputtering chamber should be degased by baking it in vacuum before it is used, and the inert gas is purified. Still some impurities stray into the plasma, and cause contamination of the sputtered film. This decreases the reliability of the device and the production yield. Such contamination is considered to be due to a minute leakage of the sputtering chamber and residual gas which are very difficult to perfectly remove by preliminary degassing. Sometimes, the residual gas is brought into the sputtering chamber together with the object itself. For example, if an aluminum film is formed over a phosphosilicate glass (PSG) substrate, the humidity is easily adsorbed by PSG and brought into the sputtering chamber. The adsorbed humidity is released by the sputtering, and poisons the sputtered aluminum film.

In ordinary sputtering apparatus, an ion plasma is formed by glow discharge in argon gas at a pressure of about 0.132Pa (10⁻³ Torr). There is a range of desirable pressure for keeping a stable plasma in the sputtering chamber. Too high or low a pressure than the desirable pressure can not maintain a stable electric discharge, and can not keep a stable plasma. In order to keep such stable plasma, the pressure of gas in the sputtering chamber is controlled by injecting inert gas, argon for example, into the chamber or controlling the pumping speed of the evacuation pump to balance the pumping speed with the injected gas flow at the desired pressure.

In order to avoid the undesirable effect of the residual gas, a higher pumping speed is the better. But if the pumping speed is very high, the flow rate of the injection gas must be high to keep the pressure in the sputtering chamber at the desired pressure for a stable plasma. This consumes a volume of the inert gas, argon gas for example, and reduces the life of the cryogenic pump. So, the availability of the sputtering apparatus decreases, because the pump must be refreshed very often. If the pumping speed is decreased to save the injection gas, the contamination gas, especially the released gas in the sputtering chamber can not be rejected perfectly. So, the quality of the sputtered film decreases. This is a dilemma for the sputtering apparatus. In practical cases, the the pumping speed is suppressed to save the inert gas and to elongate the pump life. So, the quality of the grown thin film often suffers from the contamination, and the production yield becomes unstable.

US-A-4 440 618 discloses a device which utilizes gas discharge for sputtering material. A higher and a lower pressure are chosen respectively so that the applied voltage causes the gas discharge to ignite and sustain; the discharge can be ignited at the lower pressure.

US-A-4 428 812 discloses a rapid rate deposition of a metallic compound by sputtering in which a reactive gas is introduced in a pulsed manner into a chamber together with an inert gas of constant pressure. The relation between ignition and sustainment is not identified in the total gas system.

The object of the present invention, therefore, is to provide a sputtering method which produces a high quality thin film with a high availability of the sputtering apparatus.

Another object of the present invention is to provide a method which saves the flow of the inert gas, keeping a stable glow discharge in a sputtering chamber which is evacuated with a high speed pump.

Above object can be attained by periodically varying the flow rate of the inert gas injected into the sputtering chamber. The pumping speed of the evacuation pump is kept high, in order to quickly remove the contamination gas which is released or leaked into the chamber. First, a large quantity of the inert gas is injected into the sputtering chamber for a short time period, 0.1 sec, for example. The pressure in the chamber becomes high, and the glow discharge is ignited. But, since the pumping speed is high, the pressure in the chamber goes down. At this time, a small quantity of gas is continuously injected into the sputtering chamber with a flow rate smaller than the pumping speed. The gas discharge continues though it becomes weak, and continues for a longer period, few tens of sec, for example. During this period the most effective sputtering is done, because the pumping speed is high, the contamination is evacuated quickly. Before the discharge is pinched off, the gas is again injected into the chamber for a short period of time to enhance the glow discharge, and such cycle is repeated. In such a manner, the flow rate is varied periodically.

Several manners to vary the flow rate are proposed. One is to inject the gas at a high flow rate for a very short time interval (0.2 sec.) for enhancing the discharge, and then continue to flow the gas at a low flow rate. This extends the effective time period of the glow discharge for few tens of second keeping high pumping speed. So, the discharge is done under a high evacuation speed and the total gas consumption is very small.

Another method is to periodically vary the flow rate of the injection gas to make the pressure in the sputtering chamber very quickly build up for a short time, and slowly goes down keeping the effective discharge period as long as possible.

Like such a manner, the gas consumption is saved and the life of the cryogenic pump is elongated, and hence the availability of the sputtering device is improved. Those and other advantages of the present invention will be described in more detail in the following description of preferred embodiments.

Fig. 1 schematically shows an exemplary configuration of sputtering apparatus.

Fig. 2 is a time chart illustrating a flow rate of injection gas and variation of gas pressure in the sputtering chamber for a first embodiment of the present invention.

Fig. 3 shows a gas flow line system to realize a desirable gas flow for the present invention.

Fig. 4 shows another gas flow line system to realize a desirable gas flow for the present invention.

Fig. 5 is a time chart illustrating a flow rate of gas injected into the sputtering chamber for a second embodiment of the present invention.

Same or like reference numerals or symbols designate similar or corresponding parts through the drawings.

Now the sputtering method of the present invention will be described referring some preferred embodiments. The present invention is applicable for sputtering various materials, such as metal, dielectrics, semiconductor and so on. Though the disclosure will be given with respect to an application for sputtering aluminum on a semiconductor substrate, the invention can be applied to any other objects using various materials, and the application field can be extended over various industries such as thin film circuit, optical devices and so on. The sputtering apparatus described in the following embodiment is a magnetron sputtering apparatus, which is widely used in recent industry. But the concept of the invention may be applied to any other type of glow discharge sputtering apparatus.

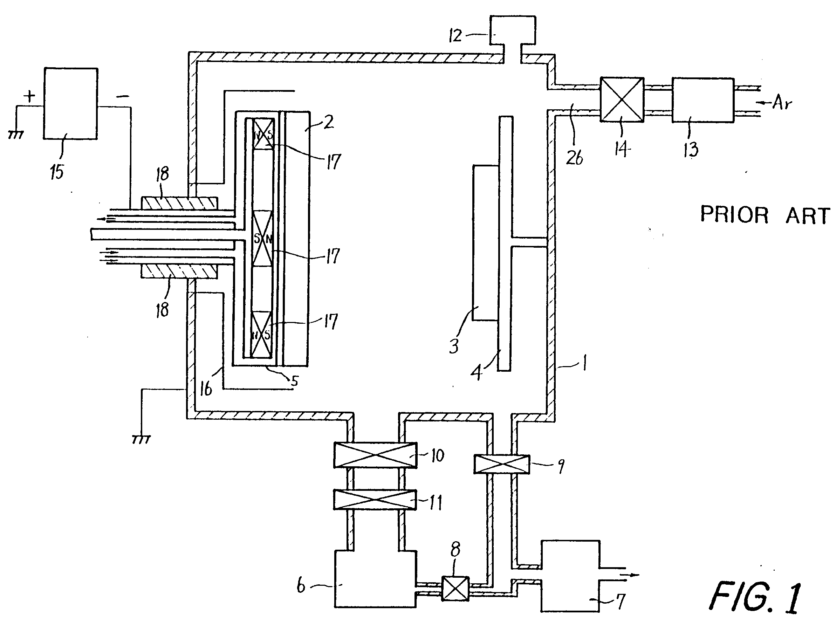

Fig. 1 shows schematically an exemplar sputtering apparatus applicable for various materials. In a sputtering chamber 1, the target 2 and the object 3 on which the thin film is to be grown are placed facing each other. The target is usually formed like a disk made of the material to be sputtered. The object 3 is held by an object holder 4, and the target 2 is supported by a target holder 5. The sputtering chamber 1 is evacuated by a cryogenic pump 6 and rotary pump 7. They are connected in cascade via a valve 8, but the rotary pump 7 can be also connected directly to the sputtering chamber 1 via another valve 9 for coarse evacuation. Between the cryogenic pump 6 and the sputtering chamber 1 is provided a gate valve 10 and a variable conductance valve 11, which controls the pumping speed. The pressure in the sputtering chamber 1 is indicated on a manometer 12. An inert gas, argon for example, is fed through a mass flow controller 13 and an electromagnetic valve 14. The target holder 5 is water cooled with a water whose inlet and outlet are respectively shown by small arrows. The negative side of a high voltage source 15 is electrically connected to the target holder 5 and the target 2, while the positive side of the high voltage source 15 is grounded. On the back side of the target holder 5 is positioned a shield plate 16 which limits the glow discharge on the surface of the target 2, to prevent sputtering the other parts of the target holder. For a magnetron sputtering apparatus, permanent magnets or electric magnets 17 are provided on the back side of the target holder 6. The target holder 5 is electrically isolated from the sputtering chamber 1 by an isolator 18. These elements described above, except the target 2 and the object 3, are all standard equipments associated with exemplary sputtering equipment. So, further description for these elements are omitted for the sake of simplicity.

Generally, for electrical sputtering the pumping speed is the higher the better, to remove the impurity or residual gas and attain the high quality of the sputtered material. So, a high speed pump is equipped in ordinary sputtering apparatus, and inert gas is injected into the sputtering chamber. In order to maintain a stable glow discharge, the pressure in the sputtering chamber should be in a proper range. Therefore, if the pump is operated in full speed, the pressure in the sputtering chamber becomes too low to maintain the glow discharge. So, the inert gas flow must be increased to balance with the pumping speed. This makes the gas consumption become very large, and decreases the activity of the cryogenic pump quickly. Therefore, the pump must be refreshed repeatedly, and the availability of the sputtering apparatus becomes low.

So, in ordinary sputtering method, the pumping speed and the flow rate of the inert gas are controlled by adjusting the variable conductance valve 11 so as to balance the pumping speed with the inert gas flow. This means the pumping speed is slowed down, therefore, the sputtered material suffers from contamination by the residual or adsorbed gas released in the sputtering chamber. This is especially undesirable for fabricating devices having very fine structures, such as LSI devices etc. The device life is decreased by the contamination, and the production yield of the device becomes unstable.

The present invention intends to solve such difficulty. The inventor noticed that when the injection of the inert gas is pinched off after the discharge begins, the glow discharge is also quenched quickly. But if a small quantity of gas is injected continuously into the sputtering chamber, the glow discharge is sustained for a longer time period though the discharge current becomes small. But if the power source is operated in a constant power mode, the electric power supplied for the glow discharge from the power source does not decrease so rapidly, because though the discharge current decreases, the voltage goes up to maintain the discharge. Therefore, the electric sputtering can be carried on effectively for a larger period of time during the glow discharge is continuing. Throughout this period, the pump is working at high speed, so, the residual gas is removed quickly, and the contamination is suppressed. On the other hand, the total gas consumption is very small, because, during most of the time, the gas flow is suppressed to a low level.

Generally, there are two pressure ranges P1, and P2 in electric gas discharge. Under the first pressure range P1, which is usually 0.264Pa - 19.8Pa (2 - 15 mTorr) for example, the gas discharge occurs at a relatively low voltage, few hundreds volts for example. Under a pressure which is lower than the first pressure range P1, the discharge does not occur unless a very high voltage is applied to cause a breakdown. In the second pressure range P2, which is adjoining below the first pressure range, the electric discharge can not occur at a low voltage of the first pressure range P1, but the discharge is substained when it is ignited in the first pressure range P1, and then the pressure is decreased to P2. But when the pressure further goes down below the second pressure range P2, the discharge is pinched off.

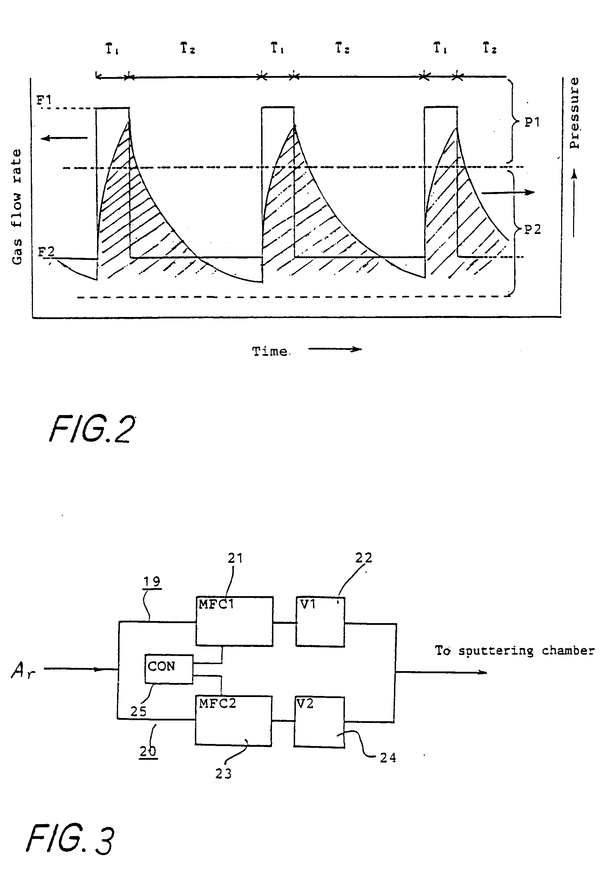

Utilizing such phenomena, the present invention proposes following control of the injection gas flow, and variation of the pressure in the sputtering chamber. Fig. 2 illustrates schematically a time chart for the inert gas flow injected into the sputtering chamber, and the variation of pressure in the sputtering chamber. In Fig. 2, abscissa shows time, the left hand side ordinate indicates the flow rate of the gas injected into the sputtering chamber, and the right hand side ordinate indicates the pressure in the sputtering chamber. The pressure ranges P1, P2 depend on kind of the injected gas, magnetic field, shape of the target and object, and the applied voltage.

According to the first embodiment, the flow rate is kept to a high level F1 during a first time period T1. The high level flow rate F1 will be called first flow rate hereinafter. By this injection of the gas, the pressure in the sputtering chamber goes up to the first pressure range P1, and the glow discharge is ignited. As soon as the glow discharge occurs, or enhanced, the gas flow rate is decreased to a low flow rate F2, and the pressure begins to go down. The low level flow rate F2 is called second flow rate herein after. But once discharge is ignited, the discharge is sustained to a pressure lower than the first pressure range P1. It should be noticed that, the discharge will be extinguished soon, if the gas flow is perfectly pinched off. But when a small amount of the gas is injected continuously as shown in Fig. 2, the glow discharge is sustained for a longer time period. Since the second flow rate F2 is set to be lower than the pumping speed, the pressure will go down further. And if the pressure becomes lower than the second pressure range P2, the discharge will be extinguished finally. Before that, namely before the gas pressure is decreased to lower than the second pressure range P2, the gas is injected again with the first flow rate F1 as shown in Fig. 2, and the glow discharge is enhanced again. The period during which the gas is injected with the low flow rate (F2) and the glow discharge is sustained will be called second time period T2 hereinafter.

Problem is how to increase the second period T2, during which the flow discharge is sustained under the second flow rate F2 of the gas injection. And how to decrease the first period T1, during which the gas is injected with the first flow rate F1, to start or enhance the glow discharge. The condition greatly depends on the size of the sputtering chamber, evacuation speed, kind of the gas, shape of the target and object, magnetic field for the magnetron sputtering operation, distance between the target and the object and so on.

But it is rather easy to empirically find out a proper condition for case by case. The chamber, pumping speed, gas, target, and object are all determined to a specific value for each case by choosing the apparatus or design of the device. The first flow rate F1 will be obtained easily by gradually increasing the flow rate, and find out the starting point of the glow discharge. The first time period T1, is the smaller the better so long as the discharge is certainly started. Therefore, it is not difficult to find out these conditions.

The remaining condition for the second flow rate F2 and the second period T2 can be also easily determined. The supplied power from the high voltage source is considered to be the power consumed by the glow discharge, and is used for bombarding the target to sputter it. If a constant DC power supply source is used, the voltage between the target and the object automatically increases when the pressure in the discharge chamber decreased, and the glow discharge is maintained. So, the output power is kept almost constant during the second period T2. But when the pressure becomes too low, the power supply source can not supply enough voltage, and the discharge current decreases quickly. This means the end of the second period T2. Too small power consumption is meaningless, because the sputtering rate becomes very small though the plasma is still sustained. Therefore, the glow discharge should be reinforced by injecting the gas before it becomes too weak. T2 is measured varying the second flow rate F2, and the optimum flow rate for elongating T2 is obtained. These conditions are all not so critical. Even if the plasma is extinguished, it does not harm any way.

It should be noticed that the second flow rate F2 should be far below the pumping speed. Since, if F2 becomes too large, F2 might balance with the pumping speed, and T2 may become very long. But this is not the solution, because the consumption of the gas increases and the refreshing period of the pump becomes short. Practically, the second flow rate F2 may be less than few tenth of the pumping speed. With such a small flow rate, sufficiently long period of T2 can be attained.

Like such a manner, the sputtering condition is easily determined for case by case. These conditions are not so critical. One example will be given for sputtering aluminum over a silicon substrate.
- Target:: aluminum disc including 1 weight % of silicon 290 mm in diameter
- Object:: silicon substrate 125 mm in diameter
Distance between the target and the object: about 55 mm Input power: 10 kW DC.
- T1:: 0.2 - 0.5 sec
- T2:: 10 - 30 sec
- F1:: 80 - 100 sccm
- F2:: 20 - 50 sccm
- P1:: 0.264Pa - 0.66Pa (2 - 5 mTorr)
- P1:: 0.066Pa - 0.264Pa (0.5 - 2 mTorr)
- Pump speed:: 1200 liter/min for argon.

The unit sccm means a standard cubic cm per minute, that is a current flow rate (cc/min) measured in one atmospheric pressure at room temperature (20°C).

Under such condition, argon gas was used for the injection gas, and by sputtering for 40 - 50 sec, an aluminum film about 1 µm thick was obtained. During the sputtering operation, the output of the DC power source varied from 400 V x 25 A at the starting time of the discharge, to 800 V x 12.5 A at the end of the second period T2. Ordinary constant DC power supply source varies its output voltage and current depending on the load resistance like such a manner.

As can be seen in above example, the first period T1 is very short compared to the second period T2. So, the sputtering is done also under the low injection flow rate, and the pump is always operated fully. Accordingly, the contamination caused by the residual gas is perfectly avoided.

Fig. 3 schematically illustrates a gas flow line system to realizes a flow of injection gas as shown in Fig. 2. This system is composed of two piping systems connected in parallel. One is a high flow rate line 19 and the other is a low flow rate line 20. The high flow rate line 19 comprises a first mass flow controller (MFC1) 21 and a first electromagnetic valve (V1) 22, while the low flow rate line 20 comprises a second mass flow controller (MFC2) 23 and a second electromagnetic valve (V2) 24. V1 and V2 are controlled by a controller (CON) 25. By these mass flow controllers 21, 23, the gas flow rate through the high flow rate line 19 is adjusted to F1, and the flow rate through the low flow rate line 20 is adjusted to F2.

Such a gas flow line system is connected to the gas inlet 26 of the sputtering chamber shown in Fig. 1, replacing the electromagnetic valve 14 and the mass flow controller 13. It will be easily understood that the flow rate will be varied as shown in Fig. 2 by simply switching the electromagnetic valves V1 and V2 to alternately open respectively with a timing T1 and T2. Such control and programming for the controller 25 is a simple one, so further description is omitted for the sake of simplicity.

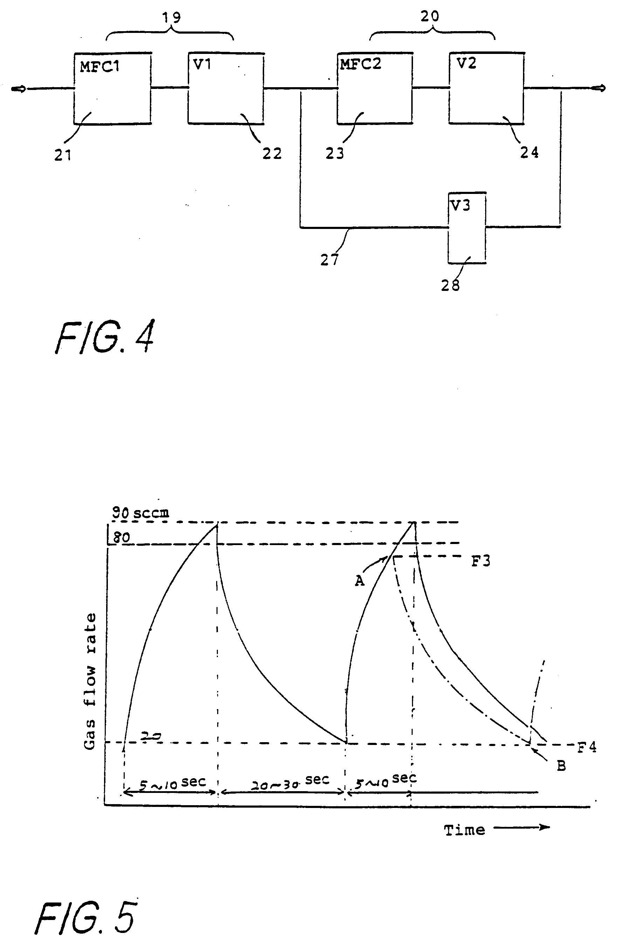

Fig. 4 schematically illustrates another gas flow line system which is applicable for realizing the gas flow rate of Fig. 2. In this system, the high flow rate line 19 and the low flow rate line 20 are connected in series to each other. These lines respectively comprises the mass flow controllers MFC1 or MFC2, and the electromagnetic valves V1 or V2, and the flow rate through these lines 19 and 20 are adjusted to be F1 and F2 respectively. The low flow rate line 20 is provided with a bypass line 27 which comprises a third electromagnetic valve (V3) 28. The electromagnetic valves V1, V2 and V3 are controlled by a controller (not shown). Such gas flow line system is connected to the gas inlet 26 of the sputtering chamber shown in Fig. 1. It will be understood that, when V1, V2 and V3 are opened, the injection gas flow rate becomes F1. If V3 is closed, and V1 and V2 are opened, the flow rate becomes F2. So, by controlling these valves it is easy to realize the gas flow of Fig. 2.

It will be understood that the flow rate of the injection gas is not necessarily a pulse form as shown in Fig. 2 in order to perform the sputtering of the present invention. Furthermore, the present invention may be performed by variation of the pressure in the sputtering chamber between a predetermined first pressure P1 and a predetermined second pressure P2. If the pressure in the sputtering chamber is varied in a manner as shown in Fig. 2, similar effects as described before will be attained.

Fig. 5 shows a flow rate of injection gas for a second embodiment of the present invention. In the figure, the ordinate is the current flow rate, and the abscissa is time. As can be seen in Fig. 5, the flow rate of the injection gas is varied rather gradually compared to the flow rate of Fig. 2. The gas flow is increased gradually, so the pressure in the sputtering chamber increases,and when the glow discharge is started or enhanced, the gas flow is decreased. So, the pressure in the sputtering chamber becomes low because the gas injection rate becomes lower than the pumping speed. Like such a manner, the glow discharge is carried on mainly in a lower gas flow range.

Similarly to the first embodiment, the higher flow rate of the injection gas by which the pressure in the sputtering chamber becomes the first pressure range P1 is called first flow rate F1, and the flow rate by which the pressure in the sputtering chamber decreases to the second pressure range P2 is called second flow rate F2. A slight difference should be noted that in the first embodiment, the value of F1 and F2 were respectively a constant value, while in the second embodiment the category of F1 is expanded to a range of the flow rate by which the pressure in the sputtering chamber increases to the first pressure range P1. Similarly, the category of F2 is also expanded to the flow rate by which the pressure in the sputtering chamber decreases to the second pressure range P2.

The variation of the flow rate like such manner is obtained rather easily by controlling the electromagnetic valve 14 in Fig. 1. For such purpose, a piezo gas flow valve for example is applicable for the electromagnetic valve 14. It varies the impedance for the gas flow by applied voltage.

The conditions how to control the valve depends on the size of the sputtering chamber, pumping speed, kind of the gas, applied voltage and so on. But it will be understood that these conditions may be easily determined like a similar manner to the first embodiment described before. The conditions are not critical, and various modifications may be possible. For example, the increment and decrement of the flow rate curve of Fig. 5 may be changed in various ways.

In an example of Fig. 5, the flow rate is increased from 20 sccm to 90 sccm in 5 - 10 sec. The glow discharge is ignited at a flow rate of about 80 sccm. This means that the pressure in the sputtering chamber reached to the first pressure range P1 at this flow rate. At 90 sccm, the flow rate is turned to decrease, and in 20 - 30 sec the flow rate is decreased to 20 sccm, then it is again increased. Such a variation of flow rate is repeated during the sputtering operation.

A modification of the second embodiment can be easily derived. In Fig. 5, when the glow discharge is ignited by the first increment of the flow rate (left hand side peak of the flow rate curve), in the following increments, the flow rate is not necessarily increased until the pressure in the sputtering chamber increases to the first pressure range P1, that corresponds to 80 sccm in current flow in Fig. 5. As shown by a chained line in Fig. 5, the flow rate may be decreased before the pressure reaches the first pressure range P1. The flow rate corresponding the turning point A in Fig. 5 will be called third flow rate F3 hereinafter. And when the flow rate is decreased to the lower turning point B in Fig. 5, that is 20 sccm for example, the flow rate is again turned to increase. The flow rate at the lower turning point B is called fourth flow rate F4.

The third flow rate F3 corresponds to a flow rate by which the pressure in the sputtering chamber goes up just below P1. The fourth flow rate F4 corresponds to a flow rate by which the pressure goes down just above the bottom of the second pressure range P2. They must be determined case by case. The values of F3 and F4 are not so critical. It will easily for the one skilled in the art to determine these values like a similar manner to finding out the value of F2 as described with respect to the first embodiment.

Like such a manner, once the glow discharge is ignited, the injection gas flow is controlled to go up and down between F3 and F4. By doing so, the total gas consumption is further decreased compared to that of the second embodiment, and hence, the recycle period of the evacuation pump is further elongated.

As has been described above, by the sputtering method of the present invention, the evacuation pump for the sputtering chamber is operated at full speed during the sputtering process. So, the residual gas in the chamber is removed away quickly, and the contamination caused by such residual gas is avoided. Therefore, a fine and high grade sputtered film can be produced. While the flow rate of the injection gas is reduced, the consumption of the gas is saved, and the recycling period of the cryogenic pump can be elongated, so, the availability of the sputtering apparatus is improved.

The present method of sputtering has additional effects that the sputtering voltage is increased in average, so the sputtering rate is increased compared to prior art sputtering methods. Further, the sputtered film has a good coverage on an object having steps on its surface. This is considered to be due to the fact that the sputtering is performed under a lower gas pressure, so, the mean free pass of the sputtered particle is increased. This enables the sputtered particle to fly along the electric lines of force which is perpendicular to the surface of the object.

In the above disclosure, the description has been done referring to a method for forming a thin film especially aluminum film over a semiconductor substrate. But the present invention is not restricted to such an application. It can be applied for fabricating various objects such as semiconductor devices, thin film circuits or devices, optical equipments and so on. The sputtered material also can be varied in variety, such as metal, dielectrics, semiconductors and so on.

## Claims

1. A method for sputtering a material on an object by a glow discharge generated in a sputtering chamber, said method comprising the steps of:
a) placing an object in a sputtering chamber having a target made of material to be sputtered on said object therein, and evacuating the sputtering chamber;
b) injecting a gas into said sputtering chamber, and increasing the pressure in said sputtering chamber to a first pressure within a first pressure range (P1) sufficient to ignite said glow discharge,
c) decreasing the flow rate of said injected gas, and thus decreasing the pressure in said sputtering chamber to a second pressure within a second pressure range (P2) such that said glow discharge cannot be ignited but can be maintained for a limited time if the glow discharge has previously been ignited;
d) before said glow discharge extinguishes, increasing the flow rate of said injected gas, and thus increasing the pressure in the sputtering chamber to a pressure within the first pressure range (P1) to at least reinforce the glow discharge; and
e) repeatedly varying the flow rate of said injected gas, and varying the pressure in the sputtering chamber between said first and second pressure ranges (P1, P2) as aforesaid to maintain said glow discharge and sputtering therein.

2. A method for sputtering material as set forth in claim 1, wherein:
in said step b), injecting the gas at a first constant flow rate (F1) for a first time period (T1) during which the pressure in said sputtering chamber increases to within said first pressure range (P1) and igniting said glow discharge;
in said step c), decreasing the gas flow rate to a second constant flow rate (F2) for a second time period (T2), which is longer than said first time period (T1), during which the pressure, in said sputtering chamber decreases to within said second pressure range (P2);
in said step d), increasing the gas flow rate to said first constant flow rate (F1) for said first time period (T1), during which the pressure in said sputtering chamber increases to within said first pressure range (P1) thereby reinforcing said glow discharge; and
in said step e), repeating said steps c) and d) during the sputtering process.

3. A method for sputtering material as set forth in claim 1 or 2, wherein said second pressure range (P2) is such that the glow discharge is on the verge of being extinguished.

4. A method for sputtering material as set forth in any of claim 1 to 3, wherein said second flow rate (F2) is less than one tenth of the evacuation speed for evacuating said sputtering chamber, and said second time period (T2) is more than ten times as long as said first time period (T1).

5. A method for sputtering material according to claim 1, wherein:
in said step b), injecting said injected gas into said sputtering chamber at a gradually increasing flow rate, and when the electric discharge is ignited, switching to step c);
in said step c), gradually decreasing said flow rate of injection gas thereby decreasing the pressure in said sputtering chamber to within the second pressure range (P2), and when the gas pressure in the sputtering chamber is decreased to within said predetermined second pressure range (P2), switching to step d);
in said step d), gradually increasing the flow rate of the injection gas thereby increasing the pressure in the sputtering chamber to within the predetermined first pressure range (P1), and when the glow discharge is reinforced, switching to step e); and
in said step e) repeating said steps c) and d) during the sputtering process.

6. A method for sputtering material according to claim 5, wherein said second pressure range (P2) is such that said glow discharge is on the verge of being extinguished.

7. A method for sputtering material accoding to claim 5 or 6, wherein said time duration for said step c) is longer than the time duration for said step d).

## Patentansprüche

1. Verfahren zum Sputtern eines Materials auf ein Objekt durch eine in einer Sputterkammer erzeugte Glimmentladung, welches Verfahren die Schritte umfaßt:
a) Anordnen eines Objekts in einer Sputterkammer, die ein Target hat, das aus auf das genannten darin befindlichen Objekt zu sputterndem Material besteht, und Evakuieren der Sputterkammer;
b) Injizieren eines Gases in die genannte Sputterkammer, und Erhöhen des Drucks in der genannten Sputterkammer auf einen ersten Druck innerhalb eines ersten Druckbereichs (P1), der ausreicht, um die genannte Glimmentladung zu zünden;
c) Senken der Flußrate des genannten injizierten Gases, und somit Verringern des Drucks in der genannten Sputterkammer auf einen zweiten Druck innerhalb eines zweiten Druckbereichs (P2) derart, daß die genannte Glimmentladung nicht gezündet werden kann, jedoch während einer begrenzten Zeit aufrechterhalten werden kann, wenn die Glimmentladung vorher gezündet wurde;
d) vor dem Erlöschen der genannten Glimmentladung, Erhöhen der Flußrate des genannten injizierten Gases, und somit Erhöhen des Drucks in der Sputterkammer auf einen Druck innerhalb des ersten Druckbereichs (P1), um die Glimmentladung zumindest zu verstärken; und
e) wiederholtes Variieren der Flußrate des genannten Injektionsgases, und Variieren des Drucks in der Sputterkammer zwischen dem genannten ersten und zweiten Druckbereich (P1, P2), wie oben erwähnt, um die genannte Glimmentladung und das Sputtern darin aufrechtzuerhalten.

2. Verfahren zum Sputtern von Material nach Anspruch 1, bei welchem:
im genannten Schritt b), Injizieren des Gases mit einer ersten konstanten Flußrate (F1) während eines ersten Zeitraums (T1), in dem sich der Druck in der genannten Sputterkammer auf einen Druck innerhalb des ersten Druckbereichs (P1) erhöht, und Zünden der genannten Glimmentladung;
im genannten Schritt c), Senken der Gasdurchflußrate auf eine zweite konstante Flußrate (F2) während eines zweiten Zeitraums (T2), der länger ist als der genannte erste Zeitraum (T1), in dem der Druck in der genannten Sputterkammer auf einen Druck innerhalb des zweiten Druckbereichs (P2) fällt;
im genannten Schritt d), Erhöhen der Gasdurchflußrate auf die genannte erste konstante Flußrate (F1) während des genannten ersten Zeitraums (T1), in dem der Druck in der genannten Sputterkammer auf einen Druck innerhalb des ersten Druckbereichs (P1) steigt, wodurch die genannte Glimmentladung verstärkt wird; und
im genannten Schritt e), Wiederholen der genannten Schritte c) und d) während des Sputterprozesses.

3. Verfahren zum Sputtern von Material nach Anspruch 1 oder 2, bei welchem der genannte zweite Druckbereich (P2) derart ist, daß die Glimmentladung beinahe gelöscht wird.

4. Verfahren zum Sputtern von Material nach einem der Ansprüche 1 bis 3, bei welchem die genannte zweite Flußrate (F2) weniger als ein Zehntel der Evakuierungsgeschwindigkeit zum Evakuieren der genannten Sputterkammer beträgt, und der genannte zweite Zeitraum (T2) mehr als zehnmal so lange wie der genannte erste Zeitraum (T1) ist.

5. Verfahren zum Sputtern von Material nach Anspruch 1, bei welchem:
im genannten Schritt b), Injizieren des genannten injizierten Gases in die genannte Sputterkammer mit einer allmählich zunehmenden Flußrate, und, wenn die elektrische Entladung gezündet ist, Übergehen zu Schritt c);
im genannten Schritt c), allmähliches Senken der genannten Flußrate von Injektionsgas, wodurch der Druck in der genannten Sputterkammer auf einen Druck innerhalb des zweiten Druckbereichs (P2) verringert wird, und, wenn der Gasdruck in der Sputterkammer auf einen Druck innerhalb des genannten vorherbestimmten zweiten Druckbereichs (P2) verringert ist, Übergehen zu Schritt d);
im genannten Schritt d), allmähliches Steigern der Flußrate des Injektionsgases, wodurch der Druck in der Sputterkammer auf einen Druck innerhalb des vorherbestimmten ersten Druckbereichs (P1) erhöht wird, und, wenn die Glimmentladung verstärkt ist, Übergehen zu Schritt e); und
im genannten Schritt e), Wiederholen der genannten Schritte c) und d) während des Sputterprozesses.

6. Verfahren zum Sputtern von Material nach Anspruch 5, bei welchem der genannte zweite Druckbereich (P2) derart ist, daß die genannte Glimmentladung beinahe gelöscht wird.

7. Verfahren zum Sputtern von Material nach Anspruch 5 oder 6, bei welchem die genannte Zeitdauer für den genannten Schritt c) länger ist als die Zeitdauer für den genannten Schritt d).

## Revendications

1. Procédé de pulvérisation d'une matière sur un objet par une décharge luminescente créée dans une chambre de pulvérisation, le procédé comprenant les étapes suivantes :
(a) la disposition d'un objet dans une chambre de pulvérisation ayant une cible formée d'une matière à pulvériser sur l'objet placé à l'intérieur, et l'évacuation de la chambre de pulvérisation,
(b) l'injection d'un gaz dans la chambre de pulvérisation, et l'augmentation de la pression dans la chambre de pulvérisation à une première pression comprise dans une première plage de pressions (P1), cette pression étant suffisante pour l'amorçage de la décharge luminescente,
(c) la réduction du débit du gaz injecté, et ainsi la réduction de la pression dans la chambre de pulvérisation à une seconde pression comprise dans une seconde plage de pressions (P2) dans laquelle une décharge luminescente ne peut pas être amorcée mais peut être entretenue pendant un temps limité si elle a d'abord été amorcée,
(d) avant l'extinction de la décharge luminescente, l'augmentation du débit du gaz injecté et ainsi l'augmentation de la pression dans la chambre de pulvérisation à une pression comprise dans la première plage de pressions (P1) de manière que la décharge luminescente soit au moins renforcée, et
(e) la variation répétée du débit du gaz injecté, et la variation de la pression dans la chambre de pulvérisation entre la première et la seconde plage de pressions (P1, P2) comme indiqué afin que la décharge luminescente soit entretenue et que la pulvérisation soit réalisée à l'intérieur de la chambre.

2. Procédé de pulvérisation d'une matière selon la revendication 1, comprenant :
dans l'étape (b), l'injection du gaz avec un premier débit constant (F1) pendant une première période (T1) pendant laquelle la pression dans la chambre de pulvérisation augmente dans la première plage de pressions (P1) et l'amorçage de la décharge luminescente, et
dans l'étape (c), la réduction du débit de gaz à un second débit constant (F2) pendant une seconde période (T2) qui est supérieure à la première période (T1) pendant laquelle la pression dans la chambre de pulvérisation diminue dans la seconde plage de pressions (P2),
dans l'étape (d), l'augmentation du débit de gaz au premier débit constant (F1) pendant la première période (T1) pendant laquelle la pression dans la chambre de pulvérisation augmente dans la première plage de pressions (P1) et renforce ainsi la décharge luminescente, et
dans l'étape (e), la répétition des étapes (c) et (d) pendant l'opération de pulvérisation.

3. Procédé de pulvérisation d'une matière selon la revendication 1 ou 2, dans lequel la seconde plage de pressions (P2) est telle que la décharge luminescente est sur le point de s'éteindre.

4. Procédé de pulvérisation d'une matière selon l'une quelconque des revendications 1 à 3, dans lequel le second débit (F2) est inférieur au dixième de la vitesse d'évacuation de la chambre de pulvérisation, et la seconde période (T2) est supérieure à dix fois la première période (T1).

5. Procédé de pulvérisation d'une matière selon la revendication 1, comprenant
dans l'étape (b), l'injection du gaz injecté dans la chambre pulvérisation avec un débit croissant progressivement et, lorsque la décharge électrique est amorcée, la commutation à l'étape (c),
dans l'étape (c), la réduction progressive du débit du gaz injecté afin que la pression dans la chambre de pulvérisation soit réduite dans la seconde plage de pressions (P2), et lorsque la pression du gaz dans la chambre de pulvérisation est réduite dans la seconde plage prédéterminée de pressions (P2), la commutation à l'étape (d),
dans l'étape (d), l'augmentation progressive du débit du gaz d'injection avec augmentation de cette manière de la pression dans la chambre de pulvérisation dans la première plage prédéterminée de pressions (P1), et, lorsque la décharge luminescente est renforcée, la commutation à l'étape (e), et
dans l'étape (e), la répétition des étapes (c) et (d) pendant l'opération de pulvérisation.

6. Procédé de pulvérisation d'une matière selon la revendication 5, dans lequel la seconde plage de pressions (P2) est telle que la décharge luminescente est sur le point de s'éteindre.

7. Procédé de pulvérisation d'une matière selon la revendication 5 ou 6, dans lequel la durée de l'étape (c) est supérieure à la durée de l'étape (d).
